# EUROPEAN PATENT APPLICATION

(11) **EP 3 806 226 A1**
(43) Date of publication of application: **14.04.2021**
(21) Application number: 19306321.1
(22) Date of filing: 09.10.2019
(51) Int. Cl.: H01M 10/48, G01R 31/36, G01R 31/396

(54) **REDUNDANT VOLTAGE MEASUREMENTS FOR BATTERY MANAGEMENT SYSTEMS**

(71) Applicant: NXP USA, Inc., Austin TX 78735 (US)
(72) Inventor: HUOT-MARCHAND, Alexis Nathanael, 31023 Toulouse Cedex 1 (FR); PANIS, Guerric, 31023 Toulouse Cedex 1 (FR); ANDREOTTI, Jean-Paul, 31023 Toulouse Cedex 1 (FR); CARMONA RAMOS, Maria de las Nieves, 31023 Toulouse Cedex 1 (FR)
(74) Representative: Bradler, Carola Romana

(57) **Abstract**

Embodiments provide redundant voltage measurements for battery management systems. A first stack of battery cells is monitored with a first battery cell controller (BCC), and a second stack of battery cells is monitored with a second BCC. At least one battery cell is a common battery cell shared by the first stack of battery cells and the second stack of battery cells. For one embodiment, a single common battery cell is used. A failure of the first BCC or the second BCC is then determined based upon monitoring of the common battery cell. If failure is detected with respect to the BCCs, an action is taken to protect the battery pack including the first stack of battery cells and the second stack of battery cells. In addition, diagnostic voltage levels can also be used to facilitate the determination of a failure for the first BCC or the second BCC.

## Description

### TECHNICAL FIELD

This technical field relates to battery monitoring and voltage measurements for battery management systems.

### BACKGROUND

Many electronic devices operate on batteries. A battery for such an electronic device is often managed by a battery management system (BMS). In part, the BMS is configured to monitor battery cells within the battery and to control their charging and discharging procedures using battery cell controllers (BCCs). For this monitoring and control, each BCC is typically coupled to a stack of battery cells and monitors cell voltages, temperature, or other parameters for the battery cells. Further, cell voltage and temperature information collected by BCCs can be transferred through a communication interface to a controller to generate battery health status, to detect defective battery cells, or to perform other battery safety or maintenance related actions.

The battery cell monitoring is important to the overall safety of the electronic device. For example, many battery packs use lithium-ion (Li-ion) battery cells, which are unstable if operating outside normal voltage ranges. If monitoring by one or more BCCs is not working properly for stacks of battery cells within a battery pack, unstable operation may occur and continue undetected. This continued unstable operation can lead to thermal breakdown, which in turn can lead to a catastrophic Li-ion battery failure, such as a fire.

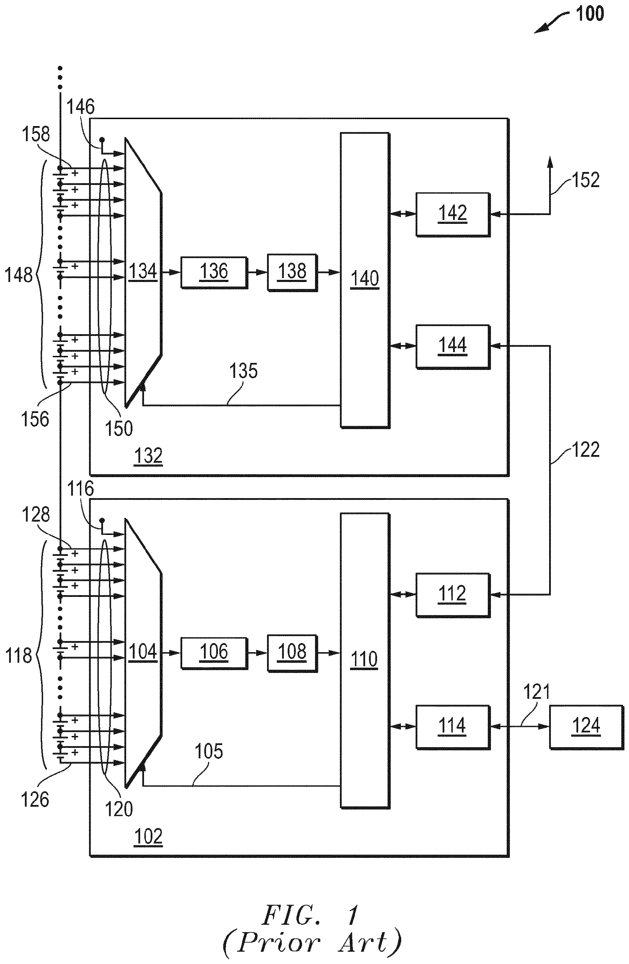

FIG. 1 (Prior Art) is a diagram of an example embodiment 100 for a battery management system including a first BCC 102 that monitors a first stack of battery cells 118 and a second BCC 132 that monitors a second stack of battery cells 148. The battery cells 118 are connected in series to provide a first voltage, and the battery cells 148 are connected in series to provide a second voltage. Battery cells 118 and battery cells 148 are also connected in series to provide a combined voltage. Additional stacks of battery cells can also be connected to battery cells 118/148 to provide an overall battery voltage for a battery pack being managed by the battery management system. The battery pack controller 124 communicates with the BCCs 102/132 and controls overall battery safety operations for the battery management system.

Looking now to BCC 102, the voltage levels for the battery cells 118 vary from a low voltage level 126 to a high voltage level 128. The individual cell voltage levels are coupled as inputs to a multiplexer 104 through cell test connections 120. The multiplexer 104 is also coupled to receive a diagnostic voltage level 116 as an input. A control signal 105 generated by logic circuit 110 is received by the multiplexer 104 and determines which voltage input is selected as an output from the multiplexer 104 to level shifter 106. This control signal 105 effectively selects one of the battery cells 118 to monitor. The level shifter 106 adjusts the voltage level to a selected range and provides a level-shifted voltage to an analog-to-digital converter (ADC) 108. The ADC 108 converts the level-shifted voltage to digital value and outputs the digital value representing the cell voltage to the logic circuit 110. The logic circuit 110 processes the digital value and transmits it to the battery pack controller 124, which determines if the selected battery cell is operating in a safe range. The logic circuit communicates with a battery pack controller 124 through communication interface 114 and communication path 121.

During operation, the voltage levels for the stacked battery cells 118 are measured by the BCC 102 through cell test connections 120. Control signal 105 is applied to the multiplexer 104 to select the battery cell to be measured. The level shifter 106 shifts the voltage level of the selected battery cell and provides a common mode voltage as an input to ADC 108. The ADC 108 performs digital conversion of the cell voltage. The resulting digital value representing the battery cell voltage is received by the battery pack controller 124 using the communication interface 114. The battery pack controller 124 can use the resulting digital value from the ADC 108 to detect if the circuitry within the BCC 102 is operating properly. Further, the diagnostic voltage level 116 can be selected as the output from the multiplexer 104, and this diagnostic voltage level 116 can be used by battery pack controller 124 to help determine proper operation of the BCC 102. It is noted that the communication interface 114 can be a transceiver, and the battery cells 118 can be Li-ion battery cells, although other cell types can also be used.

The second BCC 132 operates similarly to the first BCC 102. The second BCC 132 includes a multiplexer 134 that receives individual cell voltage levels for battery cells 148 through cell test connections 150. The multiplexer 134 is also coupled to receive a diagnostic voltage level 146 as an input. A control signal 135 generated by logic circuit 140 is received by the multiplexer 134 and determines which voltage input is selected as an output from the multiplexer 134 to level shifter 136. This control signal 135 effectively selects one of the battery cells 148 to monitor. The level shifter 136 adjusts the voltage level to a selected range and provides a level-shifted voltage to an analog-to-digital converter (ADC) 138. The ADC 138 converts the level-shifted voltage to digital value and outputs the digital value representing the cell voltage to the logic circuit 140. The logic circuit 140 processes the digital value and transmits it to the battery pack controller 124, which determines if the selected battery cell is operating in a safe range. The logic circuit communicates with a battery pack controller 124 through communication interface 144, communication path 122, communication interface 112, logic circuit 110, communication interface 114, and communication path 121. Communications with additional BCCs can also occur through communication interface 142 and communication path 152. The communication interfaces 112/114/142/144 can be transceivers. The battery cells 148 can be Li-ion battery cells, although other cell types can also be used.

It is further noted that additional BCCs can also communicate with the battery pack controller 124 through communication interfaces 112, 114, 142, 144, or other communication interfaces and paths in the battery pack. Further, it is noted that the communication interfaces 112, 114, 142, and 144 can be wired interfaces, wireless interfaces, or a combination thereof, and intervening communication circuitry can also be provided. The logic circuits 110 and 140 can be configured to process information transmitted by other BCCs or can be configured to pass those communications through without processing. Other variations can also be implemented.

While the safety monitoring techniques of FIG. 1 (Prior Art) detect failures, the overall detection accuracy is low. This low detection accuracy degrades safety margins and reduces the full-charge level and full-discharge levels allowed for the battery pack thereby reducing the usable energy available from the battery pack. To resolve this problem and improve safety for the battery operation, one prior solution duplicates the circuitry within each BCC to create redundant and independent voltage monitoring systems.

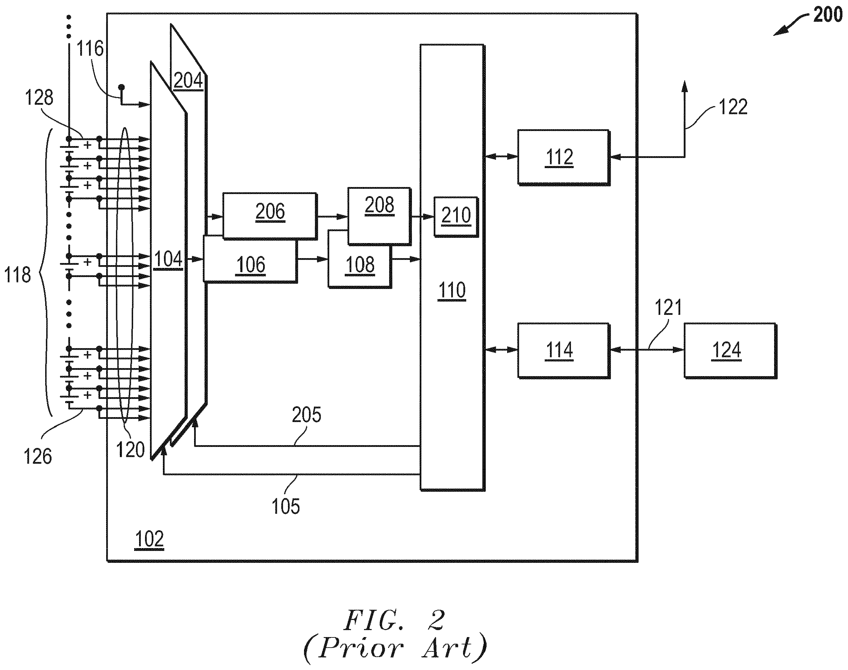

FIG. 2 (Prior Art) is a diagram of an example embodiment 200 where redundant voltage measurement circuitry is included for the BCC 102. As shown, a duplicate multiplexer 204, a duplicate level shifter 206, and a duplicate ADC 208 provide redundant voltage measurement circuitry. Further, redundant logic blocks, such as filters 210, can also be included in the logic circuit 110. In addition to control signal 105 output to multiplexer 104, the logic circuit 110 also outputs a control signal 205 to the duplicate multiplexer 204 to determine which voltage input is selected as an output from the duplicate multiplexer 204 to the duplicate level shifter 206. The monitoring results from this redundant monitoring circuitry can also be communicated to the battery pack controller 124. The battery pack controller 124 can then compare the results of the two independent monitoring paths to determine if a failure is occurring within the BCC 102. For example, results from the normal measurement circuitry 104/106/108 and the redundant measurement circuitry 204/206/208 can be compared to improve accuracy of safety monitoring. While the technique of FIG. 2 (Prior Art) improves accuracy and safety through the redundant voltage measurement for the battery cells 118, this solution significantly increases cost due to large the area increase and additional circuitry required for the duplicated blocks.

### SUMMARY

Aspects of the disclosure are defined in the accompanying claims.

In a first aspect, there is provided a system for battery management, comprising: a first battery cell controller (BCC) coupled to monitor a first stack of battery cells; and a second BCC coupled to monitor a second stack of battery cells; wherein at least one battery cell is a common battery cell shared by the first stack of battery cells and the second stack of battery cells.

In one or more embodiments, the system may further comprise a controller coupled to receive digital values representing monitored cell voltages from the first BCC and the second BCC.

In one or more embodiments, the controller may be configured to determine a failure of the first BCC or the second BCC by comparing a first digital value representing a cell voltage for the common battery cell measured by the first BCC and a second digital value representing a cell voltage for the common battery cell measured by the first BCC.

In one or more embodiments, the controller may be further configured to use digital values associated with diagnostic voltage levels to determine the failure of the first BCC or the second BCC.

In one or more embodiments, only a single battery cell is a common battery cell shared by the first stack of battery cells and the second stack of battery cells.

In one or more embodiments, the single battery cell may be a top battery cell within the first stack of battery cells and a bottom battery cell within the second stack of battery cells.

In one or more embodiments, the system may further comprise one or more additional BCCs, each additional BCC being coupled to monitor an additional stack of battery cells having at least one battery cell shared with a stack of battery cells monitored by another BCC.

In one or more embodiments, each BCC may comprise a multiplexer coupled to receive voltage levels from the battery cells as inputs, the multiplexer selecting one of the voltage levels as an output to monitor based upon a control signal.

In one or more embodiments, the multiplexer in each BCC may also receive a diagnostic voltage level as an input that is selectable as the output based upon the control signal.

In one or more embodiments, each BCC may further comprise a level shifter coupled to receive the output of the multiplexer, an analog-to-digital converter (ADC) coupled to receive an output of the level shifter, and a logic circuit coupled to receive a digital value from the ADC and to output the control signal.

In a second aspect, there is provided a method for battery management, comprising: monitoring a first stack of battery cells with a first battery cell controller (BCC); monitoring a second stack of battery cells with a second BCC, wherein at least one battery cell is a common battery cell shared by the first stack of battery cells and the second stack of battery cells; determining a failure of the first BCC or the second BCC based upon monitoring of the common battery cell; and taking at least one action to protect a battery pack including the first stack of battery cells and the second stack of battery cells based upon the determining.

In one or more embodiments, the at least one action may comprise shutting down the first BCC if the failure is detect in the first BCC or shutting down the second BCC if the failure is detected in the second BCC.

In one or more embodiments, the at least one action may comprise transmitting a warning message indicating the failure.

In one or more embodiments, the method may further comprise generating with the first BCC and the second BCC digital values representing monitored cell voltages.

In one or more embodiments, the determining may comprise determining, with a controller, the failure of the first BCC or the second BCC by comparing a first digital value representing a cell voltage for the common battery cell measured by the first BCC and a second digital value representing a cell voltage for the common battery cell measured by the first BCC.

In one or more embodiments, the method may further comprise, with the controller, using digital values associated with diagnostic voltage levels to determine the failure of the first BCC or the second BCC.

In one or more embodiments, only a single battery cell is a common battery cell shared by the first stack of battery cells and the second stack of battery cells, and the single battery cell may be a top battery cell within the first stack of battery cells and a bottom battery cell within the second stack of battery cells.

In one or more embodiments, the method may further comprise monitoring one or more additional stacks of battery cells with an additional BCC for each additional stack of battery cells, each additional stack of battery cells having at least one battery cell shared with a stack of battery cells monitored by another BCC.

In one or more embodiments, the method may further comprise, for each of the first BCC and the second BCC, receiving voltage levels from the battery cells as inputs to a multiplexer and selecting one of the voltage levels as an output to monitor from the multiplexer based upon a control signal.

In one or more embodiments, the method may further comprise, for each of the first BCC and the second BCC, receiving a diagnostic voltage level as an input to the multiplexer that is selectable as the output based upon the control signal.

### DESCRIPTION OF THE DRAWINGS

It is noted that the appended figures illustrate only example embodiments and are, therefore, not to be considered as limiting the scope of the present invention. Elements in the figures are illustrated for simplicity and clarity and have not necessarily been drawn to scale.
FIG. 1 (Prior Art) is a diagram of an example embodiment of a prior solution for a battery management system including a first BCC that monitors a first stack of battery cells and a second BCC that monitors a second stack of battery cells.
FIG. 2 (Prior Art) is a diagram of an example embodiment for a prior solution where redundant voltage measurement circuitry is included for the BCC.
FIG. 3 is a block diagram of an example embodiment where a first BCC and a second BCC share a common battery cell and provide redundant cell measurements for this common battery cell to improve battery management as described herein.
FIG. 4 is a process flow diagram of an example embodiment where redundant voltage measurements for battery management systems are provided using shared battery cells.

### DETAILED DESCRIPTION

Embodiments are disclosed that provide redundant voltage measurements for battery management systems. Disclosed embodiments monitor a first stack of battery cells with a first battery cell controller (BCC) and monitor a second stack of battery cells with a second BCC. Further, at least one battery cell is a common battery cell shared by the first stack of battery cells and the second stack of battery cells. For one embodiment, a single common battery cell is used that is a top battery cell for the first stack of battery cells and a bottom battery cell for the second stack of battery cells. A failure of the first BCC or the second BCC is then determined based upon monitoring of the common battery cell. If failure is detected with respect to the BCCs, an action is taken to protect the battery pack including the first stack of battery cells and the second stack of battery cells. In addition, diagnostic voltage levels can also be used to facilitate the determination of a failure for the first BCC or the second BCC. A variety of additional or different features and variations can also be implemented.

As described above, prior solutions provide fault tolerance for battery management systems through complete duplicate paths and related circuitry for cell voltage monitoring. In contrast, disclosed embodiments provide redundant cell voltage measurement and independent monitoring for BCCs without requiring the duplicate circuitry of the prior solutions that significantly increases the cost and area requirements for the BCCs. For the disclosed embodiments, fault tolerance and system safety are provided in a lower cost system. For one embodiment, a circuit arrangement includes a battery management system where at least one battery cell is coupled as a shared, common cell between two BCCs allowing the BCCs to be crosschecked with each other for correct functionality and accuracy of cell voltage monitoring.

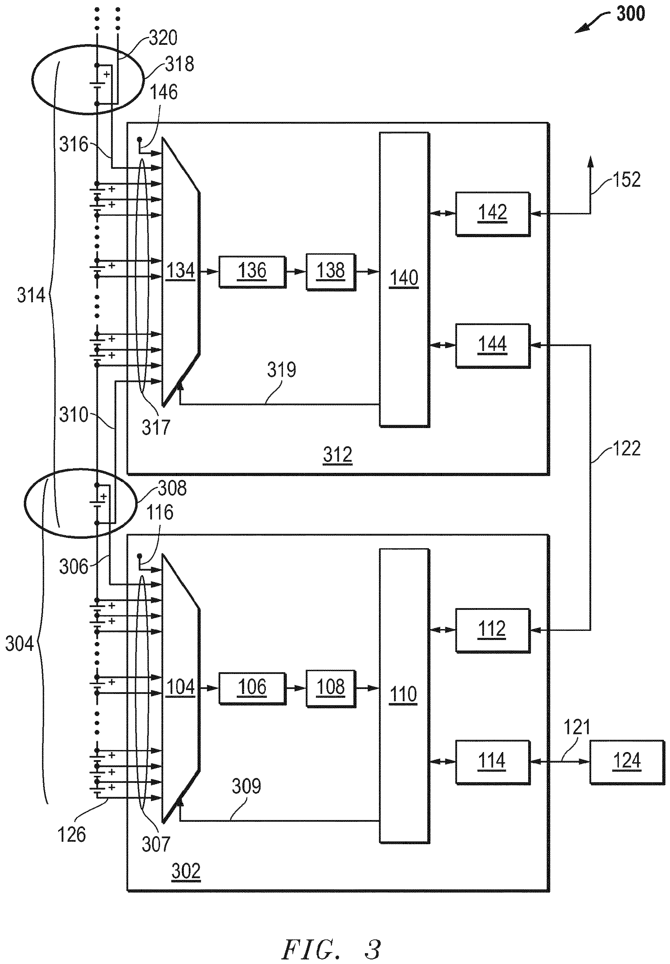

FIG. 3 is a block diagram of an example embodiment 300 where a first BCC 302 and a second BCC 312 share a common battery cell 308 and provide redundant cell measurements for this common battery cell 308. For BCC 302, common battery cell 308 is the top cell in a first stack of battery cells 304 and provides a high voltage level 306 for this stack to multiplexer 104. For BCC 312, common battery cell 308 is the bottom cell in a second stack of battery cells 314 and provides a low voltage level 310 for this stack to multiplexer 134.

The BCC 302 operates similarly to the BCC 102 described in FIG. 1 (Prior Art). The voltage levels for the battery cells 304 vary from a low voltage level 126 to a high voltage level 306 associated with the common battery cell 308. The BCC 302 includes a multiplexer 104 that receives cell voltage levels for the battery cells 308 through cell test connections 307. The multiplexer 104 is also coupled to receive a diagnostic voltage level 116 as an input. A control signal 309 generated by logic circuit 110 is received by the multiplexer 104 and determines which voltage input is selected as an output from the multiplexer 104 to level shifter 106. This control signal 309 effectively selects one of the battery cells 304 to monitor. The level shifter 106 adjusts the voltage level to a selected range and provides a level-shifted voltage to an analog-to-digital converter (ADC) 108. The ADC 108 converts the level-shifted voltage to digital value and outputs the digital value representing the cell voltage to the logic circuit 110. The logic circuit 110 processes the digital value and transmits it to the battery pack controller 124, which determines if the selected battery cell is operating in a safe range. The logic circuit 110 communicates with a battery pack controller 124 through communication interface 114 and communication path 121. Communications with a second BCC 312 can also occur through communication interface 112 and communication path 122. The communication interfaces 112/114 can be transceivers. The battery cells 304 can be Li-ion battery cells, although other cell types can also be used.

The second BCC 312 operates similarly to the first BCC 302. The voltage levels for the battery cells 314 vary from a low voltage level 310 to a high voltage level 316. The low voltage level 310 is associated with the common battery cell 308. The high voltage level 316 is associated with a common battery cell 318, which is shared with an additional stack of battery cells monitored by an additional BCC (not shown). This additional BCC would receive a low voltage level 320 from the common battery cell 318. The BCC 312 includes a multiplexer 134 that receives cell voltage levels through cell test connections 317. The multiplexer 134 is also coupled to receive a diagnostic voltage level 146 as an input. A control signal 319 generated by logic circuit 140 is received by the multiplexer 134 and determines which voltage input is selected as an output to level shifter 136. This control signal 319 effectively selects one of the battery cells 314 to monitor. The level shifter 136 adjusts the voltage level to a selected range and provides a level-shifted voltage to an analog-to-digital converter (ADC) 138. The ADC 138 converts the level-shifted voltage to digital value and outputs the digital value representing the cell voltage to the logic circuit 140. The logic circuit 140 processes the digital value and transmits it to the battery pack controller 124, which determines if the selected battery cell is operating in a safe range. The logic circuit 140 communicates with a battery pack controller 124 through communication interface 144, communication path 122, communication interface 112, logic circuit 110, communication interface 114, and communication path 121. Communications with an additional BCC can also occur through communication interface 142 and communication path 152. The communication interfaces 112/114/142/144 can be transceivers. The battery cells 304 can be Li-ion battery cells, although other cell types can also be used.

It is further noted that additional BCCs can also communicate with the battery pack controller 124 through communication interfaces 112, 114, 142, 144, or other communication interfaces/paths in the battery pack. Further, it is noted that the communication interfaces 112, 114, 142, and 144 can be wired interfaces, wireless interfaces, or a combination thereof, and intervening communication circuitry can also be provided. The logic circuits 110 and 140 can be configured to process information transmitted by other BCCs or can be configured to pass those communications through without processing. Other variations can also be implemented.

During operation, the common battery cell 308 allows for redundant measurement and checks of the circuitry within BCC 302 and within BCC 312 without requiring duplication of that circuitry within BCC 302 and BCC 312. For example, the battery pack controller 124 receives a first digital value representing the cell voltage for battery cell 308 from BCC 302 and a second digital value representing the cell voltage for battery cell 308 from BCC 312. The battery pack controller 124 can then compare these two digital values to see if they match. If they do not match, the battery pack controller 124 can determine that either the measurement circuitry within the BCC 302 or the measurement circuitry within BCC 312 has failed. As such, redundant measurement circuity for BCC 302 is effectively provided through the circuitry within BCC 312 without requiring additional redundant circuitry within BCC 302. Similarly, redundant measurement circuity for BCC 312 is effectively provided through the circuitry within BCC 302 without requiring additional redundant circuitry within BCC 312.

The common battery cell 318, which is shared by the second stack of battery cells 148 with an additional stack of battery cells, can be used in the same way to allow the battery pack controller 124 to compare digital values generated by BCC 312 and an additional BCC that also monitors the common battery cell 318. Common battery cells and comparison checks can continue for other BCCs and battery cells included within the battery pack.

It is noted that a tolerance level can be used for the comparison and matching of digital values output by two BCCs monitoring a common battery cell, such as common battery cells 308 and 318. For example, a failure can be determined to have occurred only if the difference in digital values exceeds a selected tolerance level. This tolerance level can be any desired tolerance level, such as the two values must be within one percent of each other. Other tolerances and variations could also be used.

When a failure is detected, actions can be taken to protect the battery pack including the stack of battery cells 304 and the stack of battery cells 314. For example, the first BCC can be shut down if the failure is detected in the first BCC, and the second BCC can be shut down if the failure is detected in the second BCC. The maximum and minimum charging levels for the battery cells 304/314 can also be adjusted. Further, a warning message can be transmitted indicating the failure. For example, the battery pack controller 124 can transmit a warning message to a host processor for the electronic device using the battery system. Other protective actions can also be taken, and combinations of two or more actions can also be taken. For example, when a failure is detected, the action to protect the battery pack can be to open a relay or contactor (*e.g.,* electronic fuse, pyro-mechanical switch, pyro-fuse, semiconductor switch, *etc.*) to disconnect the battery pack from the system.

It is noted that the battery pack controller 124 can use comparisons between the digital values generated by adjacent BCCs with respect to a common battery cell to identify a failing BCC within a stack of BCCs for a battery pack. TABLE 1 and TABLE 2 below provide example embodiments where five BCCs monitor stacks of battery cells within a battery pack, and the battery pack controller 124 has determined that a BCC has failing measurement circuitry.

In TABLE 1, BCC2 and BCC3 generate different digital values (V2-1 and V2-2) for their shared battery cell. BCC3 and BCC4 also generate different digital values (V3-1 and V3-2) for their shared battery cell. Due to these mismatches, BCC2, BCC3, and BCC4 could possibly include faulty measurement circuitry. However, BCC2 is deemed to be working properly because BCC2 generates the same digital value (V1) for the shared battery cell with BCC1. Similarly, BCC4 is deemed to be working properly because BCC4 generates the same digital value (V4) for the shared battery cell with BCC5. In contrast, BCC3 is deemed to have faulty measurement circuitry that is causing the mismatch because it mismatches with both BCC2 and BCC4.

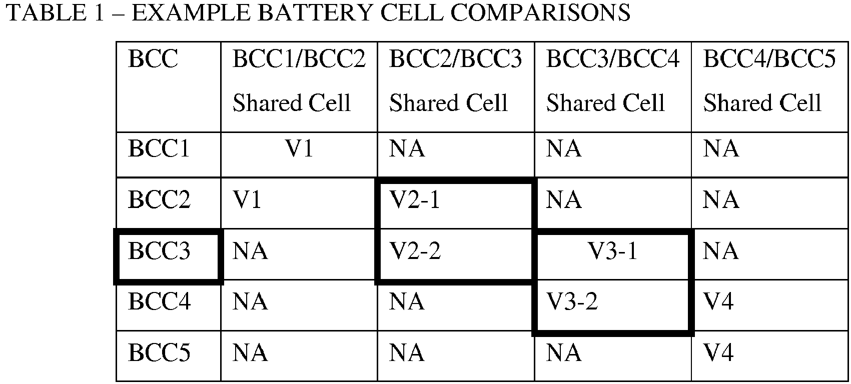

In TABLE 2, BCC1 and BCC2 generate different digital values (V1-1 and V1-2) for their shared battery cell. Due to the mismatch, BCC1 and BCC2 could possibly include faulty measurement circuitry. However, BCC2 is deemed to be working properly because BCC2 generates the same digital value (V2) for the shared battery cell with BCC3. BCC1 is then deemed to have the faulty measurement circuitry. In addition to BCC2, the remaining BCCs are also deemed to be working properly. BCC3 generates the same digital value (V3) for the shared battery cell with BCC4, and BCC4 generates the same digital value (V4) for the shared battery call with BCC5.

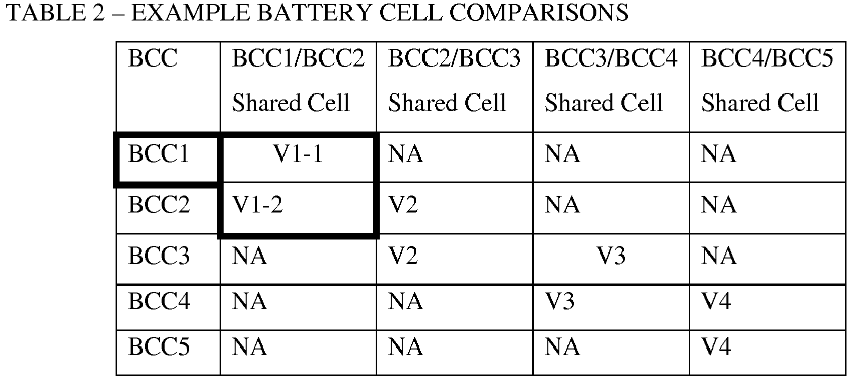

In addition to the shared battery cells 308/318, the embodiment 300 also includes the diagnostic voltage levels 116/146 that are received by multiplexers 104/134, respectively. These diagnostic levels 116/146 can be used to improve safety, for example, by allowing detection of errors such as stuck-at failures in the multiplexers 104/134. Further, the diagnostic voltage levels 116/146 can be applied to a BCC 302/312 after a mismatch is detected between measurements for the shared battery cell 308. These diagnostic voltage levels 116/146 can be used to help determine which of the BCCs 302/312 includes faulty measurement circuitry. For example, where BCCs 302/312 are the only BCCs in a battery pack, these diagnostics voltage levels 116/146 can be used to determine whether BCC 302 or BCC 312 has failed.

For the embodiment depicted in FIG. 3, the common battery cell 308 is the top cell for the first stack of battery cells 304 monitored by BCC 302 and is the bottom cell for the second stack of battery cells 314 monitored by BCC 312. It is noted that more than one battery cell could be shared by adjacent BCCs in additional embodiments. For example, the top N cells within the battery cells 304 monitored by BCC 302 could be shared as the bottom N cells within the battery cells 314 monitored by BCC 312. The control signals 309 and 319 can then select the appropriate cell test connections within the connections 120/150 so that voltage levels can be measured and compared by the measurement circuitry for the BCCs 302/312. Other variations could also be implemented.

It is noted that battery pack controller 124 can be a microcontroller, a microprocessor, a programmable logic device, or other programmable circuit that executes program instructions stored in a non-volatile data storage device to carry out the functions described herein. It is further noted that that logic circuits 110/140 can be implemented as a dedicated logic circuit, dedicated controller, or other hardware digital solution that implements the control actions and functions described herein. The logic circuits 110/140 can also be implemented as a microcontroller, a microprocessor, a programmable logic device, or other programmable circuit that executes program instructions stored in a non-volatile data storage device to carry out the control actions and functions described herein. Other variations can also be implemented.

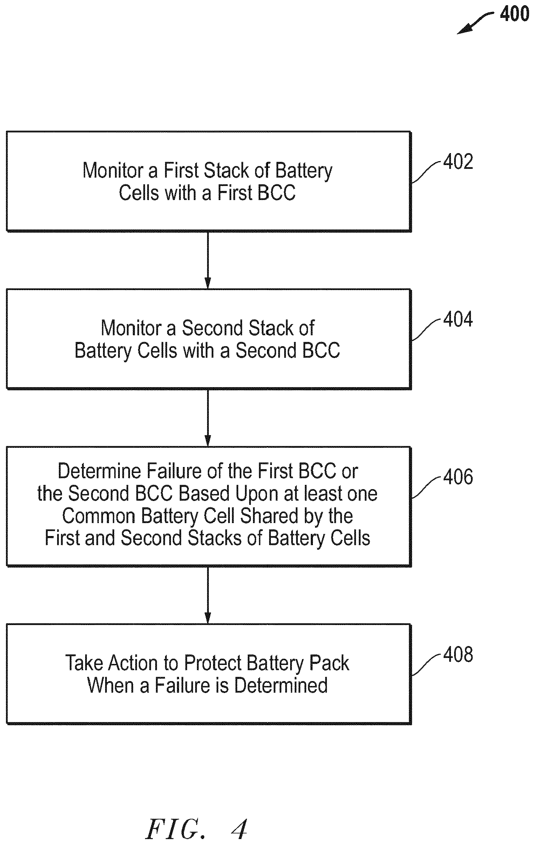

FIG. 4 is a process flow diagram of an example embodiment 400 where redundant voltage measurements for battery management systems are provided using shared battery cells. In block 402, a first stack of battery cells is monitored with a first battery cell controller (BCC). In block 404, a second stack of battery cells is monitored with a second BCC. Further, at least one battery cell is a common battery cell shared by the first stack of battery cells and the second stack of battery cells. For one embodiment, a single common battery cell is used that is a top battery cell for the first stack of battery cells and a bottom battery cell for the second stack of battery cells. In block 406, a failure of the first BCC or the second BCC is then determined based upon monitoring of the common battery cell. In block 408, an action is taken to protect the battery pack including the first stack of battery cells and the second stack of battery cells when a failure is determined for the first BCC or the second BCC. As described above, these actions can include shutting down the first BCC if the failure is detected in the first BCC, shutting down the second BCC if the failure is detected in the second BCC, transmitting a warning message indicating the failure, or another protective action. Further, combinations of actions can also be taken. It is further noted that embodiment 400 provides one example embodiment, and additional or different process steps could also be used while still taking advantage of the techniques describe herein. For example, diagnostic voltage levels can also be used to facilitate the determination of a failure for the first BCC or the second BCC. Other variations can also be implemented.

As described herein, a variety of embodiments can be implemented and different features and variations can be implemented, as desired.

For one embodiment, a system for battery management is disclosed including a first battery cell controller (BCC) coupled to monitor a first stack of battery cells and a second BCC coupled to monitor a second stack of battery cells. Further, at least one battery cell is a common battery cell shared by the first stack of battery cells and the second stack of battery cells.

In additional embodiments, the system includes a controller coupled to receive digital values representing monitored cell voltages from the first BCC and the second BCC. In further embodiments, the controller is configured to determine a failure of the first BCC or the second BCC by comparing a first digital value representing a cell voltage for the common battery cell measured by the first BCC and a second digital value representing a cell voltage for the common battery cell measured by the first BCC. In still further embodiments, the controller is further configured to use digital values associated with diagnostic voltage levels to determine the failure of the first BCC or the second BCC.

In additional embodiments, only a single battery cell is a common battery cell shared by the first stack of battery cells and the second stack of battery cells. In further embodiments, the single battery cell is a top battery cell within the first stack of battery cells and a bottom battery cell within the second stack of battery cells.

In additional embodiments, the system also includes one or more additional BCCs where each additional BCC is coupled to monitor an additional stack of battery cells having at least one battery cell shared with a stack of battery cells monitored by another BCC.

In additional embodiments, each BCC includes a multiplexer coupled to receive voltage levels from the battery cells as inputs, and the multiplexer selects one of the voltage levels as an output to monitor based upon a control signal. In further embodiments, the multiplexer in each BCC also receives a diagnostic voltage level as an input that is selectable as the output based upon the control signal. In further embodiments, each BCC further includes a level shifter coupled to receive the output of the multiplexer, an analog-to-digital converter (ADC) coupled to receive an output of the level shifter, and a logic circuit coupled to receive a digital value from the ADC and to output the control signal.

For one embodiment, a method for battery management is disclosed including monitoring a first stack of battery cells with a first battery cell controller (BCC), monitoring a second stack of battery cells with a second BCC where at least one battery cell is a common battery cell shared by the first stack of battery cells and the second stack of battery cells, determining a failure of the first BCC or the second BCC based upon monitoring of the common battery cell, and taking at least one action to protect a battery pack including the first stack of battery cells and the second stack of battery cells based upon the determining.

In additional embodiments, the at least one action includes shutting down the first BCC if the failure is detected in the first BCC or shutting down the second BCC if the failure is detected in the second BCC. In further additional embodiments, the at least one action comprises transmitting a warning message indicating the failure.

In additional embodiments, the method includes generating with the first BCC and the second BCC digital values representing monitored cell voltages. In further embodiments, the determining includes determining, with a controller, the failure of the first BCC or the second BCC by comparing a first digital value representing a cell voltage for the common battery cell measured by the first BCC and a second digital value representing a cell voltage for the common battery cell measured by the first BCC. In still further embodiments, the method includes, with the controller, using digital values associated with diagnostic voltage levels to determine the failure of the first BCC or the second BCC.

In additional embodiments, only a single battery cell is a common battery cell shared by the first stack of battery cells and the second stack of battery cells, and the single battery cell is a top battery cell within the first stack of battery cells and a bottom battery cell within the second stack of battery cells.

In additional embodiments, the method includes monitoring one or more additional stacks of battery cells with an additional BCC for each additional stack of battery cells, and each additional stack of battery cells has at least one battery cell shared with a stack of battery cells monitored by another BCC.

In additional embodiments, the method includes, for each of the first BCC and the second BCC, receiving voltage levels from the battery cells as inputs to a multiplexer and selecting one of the voltage levels as an output to monitor from the multiplexer based upon a control signal. In further embodiments, the method includes, for each of the first BCC and the second BCC, receiving a diagnostic voltage level as an input to the multiplexer that is selectable as the output based upon the control signal.

Embodiments provide redundant voltage measurements for battery management systems. A first stack of battery cells is monitored with a first battery cell controller (BCC), and a second stack of battery cells is monitored with a second BCC. At least one battery cell is a common battery cell shared by the first stack of battery cells and the second stack of battery cells. For one embodiment, a single common battery cell is used. A failure of the first BCC or the second BCC is then determined based upon monitoring of the common battery cell. If failure is detected with respect to the BCCs, an action is taken to protect the battery pack including the first stack of battery cells and the second stack of battery cells. In addition, diagnostic voltage levels can also be used to facilitate the determination of a failure for the first BCC or the second BCC.

It is further noted that the functional blocks, components, systems, devices, or circuitry described herein can be implemented using hardware, software, or a combination of hardware and software along with analog circuitry as needed. For example, the disclosed embodiments can be implemented using one or more programmed integrated circuits that are programmed to perform the functions, tasks, methods, actions, or other operational features described herein for the disclosed embodiments. The one or more programmed integrated circuits can include, for example, one or more processors or configurable logic devices (CLDs) or a combination thereof. The one or more processors can be, for example, one or more central processing units (CPUs), controllers, microcontrollers, microprocessors, hardware accelerators, ASICs (application specific integrated circuit), or other integrated processing devices. The one or more CLDs can be, for example, one or more CPLDs (complex programmable logic devices), FPGAs (field programmable gate arrays), PLAs (programmable logic array), reconfigurable logic circuits, or other integrated logic devices. Further, the programmed integrated circuits, including the one or more processors, can be programmed to execute software, firmware, code, or other program instructions that are embodied in one or more non-transitory tangible computer-readable mediums to perform the functions, tasks, methods, actions, or other operational features described herein for the disclosed embodiments. The programmed integrated circuits, including the one or more CLDs, can also be programmed using logic code, logic definitions, hardware description languages, configuration files, or other logic instructions that are embodied in one or more non-transitory tangible computer-readable mediums to perform the functions, tasks, methods, actions, or other operational features described herein for the disclosed embodiments. In addition, the one or more non-transitory tangible computer-readable mediums can include, for example, one or more data storage devices, memory devices, flash memories, random access memories, read only memories, programmable memory devices, reprogrammable storage devices, hard drives, floppy disks, DVDs, CD-ROMs, or any other non-transitory tangible computer-readable mediums. Other variations can also be implemented while still taking advantage of the techniques described herein.

Unless stated otherwise, terms such as "first" and "second" are used to arbitrarily distinguish between the elements such terms describe. Thus, these terms are not necessarily intended to indicate temporal or other prioritization of such elements.

Further modifications and alternative embodiments of the described systems and methods will be apparent to those skilled in the art in view of this description. It will be recognized, therefore, that the described systems and methods are not limited by these example arrangements. It is to be understood that the forms of the systems and methods herein shown and described are to be taken as example embodiments. Various changes may be made in the implementations. Thus, although the invention is described herein with reference to specific embodiments, various modifications and changes can be made without departing from the scope of the present invention. Accordingly, the specification and figures are to be regarded in an illustrative rather than a restrictive sense, and such modifications are intended to be included within the scope of the present invention. Further, any benefits, advantages, or solutions to problems that are described herein with regard to specific embodiments are not intended to be construed as a critical, required, or essential feature or element of any or all the claims.

## Claims

1. A system for battery management, comprising:
a first battery cell controller (BCC) coupled to monitor a first stack of battery cells; and
a second BCC coupled to monitor a second stack of battery cells;
wherein at least one battery cell is a common battery cell shared by the first stack of battery cells and the second stack of battery cells.

2. The system of claim 1, further comprising a controller coupled to receive digital values representing monitored cell voltages from the first BCC and the second BCC.

3. The system of claim 2, wherein the controller is configured to determine a failure of the first BCC or the second BCC by comparing a first digital value representing a cell voltage for the common battery cell measured by the first BCC and a second digital value representing a cell voltage for the common battery cell measured by the first BCC.

4. The system of claim 3, wherein the controller is further configured to use digital values associated with diagnostic voltage levels to determine the failure of the first BCC or the second BCC.

5. The system of any preceding claim, wherein only a single battery cell is a common battery cell shared by the first stack of battery cells and the second stack of battery cells.

6. The system of claim 5, wherein the single battery cell is a top battery cell within the first stack of battery cells and a bottom battery cell within the second stack of battery cells.

7. The system of any preceding claim, further comprising one or more additional BCCs, each additional BCC being coupled to monitor an additional stack of battery cells having at least one battery cell shared with a stack of battery cells monitored by another BCC.

8. The system of any preceding claim, wherein each BCC comprises a multiplexer coupled to receive voltage levels from the battery cells as inputs, the multiplexer selecting one of the voltage levels as an output to monitor based upon a control signal.

9. The system of claim 8, wherein the multiplexer in each BCC also receives a diagnostic voltage level as an input that is selectable as the output based upon the control signal.

10. The system of claim 8 or 9, wherein each BCC further comprises a level shifter coupled to receive the output of the multiplexer, an analog-to-digital converter (ADC) coupled to receive an output of the level shifter, and a logic circuit coupled to receive a digital value from the ADC and to output the control signal.

11. A method for battery management, comprising:
monitoring a first stack of battery cells with a first battery cell controller (BCC);
monitoring a second stack of battery cells with a second BCC, wherein at least one battery cell is a common battery cell shared by the first stack of battery cells and the second stack of battery cells;
determining a failure of the first BCC or the second BCC based upon monitoring of the common battery cell; and
taking at least one action to protect a battery pack including the first stack of battery cells and the second stack of battery cells based upon the determining.

12. The method of claim 11, wherein the at least one action comprises shutting down the first BCC if the failure is detect in the first BCC or shutting down the second BCC if the failure is detected in the second BCC.

13. The method of claim 11 or 12, wherein the at least one action comprises transmitting a warning message indicating the failure.

14. The method of any of claims 11 to 13, further comprises generating with the first BCC and the second BCC digital values representing monitored cell voltages.

15. The method of claim 14, wherein the determining comprises determining, with a controller, the failure of the first BCC or the second BCC by comparing a first digital value representing a cell voltage for the common battery cell measured by the first BCC and a second digital value representing a cell voltage for the common battery cell measured by the first BCC.

## Amended claims

### Amended claims in accordance with Rule 137(2) EPC.

1. A system (300) for battery management, comprising:
a first battery cell controller, BCC, (302) coupled to monitor a first stack of battery cells (304); and
a second BCC (312) coupled to monitor a second stack of battery cells (314);
wherein at least one battery cell (308) is a common battery cell shared by the first stack of battery cells (304) and the second stack of battery cells (314); and
the system further comprising a controller (124) configured to:
determine a failure of the first BCC (302) or the second BCC (312) based upon monitoring of the common battery cell (308); and
take at least one action to protect a battery pack including the first stack of battery cells (304) and the second stack of battery cells (314) based upon the determination.

2. The system of claim 1, wherein the controller is coupled to receive digital values representing monitored cell voltages from the first BCC and the second BCC.

3. The system of claim 2, wherein the controller is configured to determine a failure of the first BCC or the second BCC by comparing a first digital value representing a cell voltage for the common battery cell measured by the first BCC and a second digital value representing a cell voltage for the common battery cell measured by the first BCC.

4. The system of claim 3, wherein the controller is further configured to use digital values associated with diagnostic voltage levels to determine the failure of the first BCC or the second BCC.

5. The system of any preceding claim, wherein only a single battery cell is a common battery cell shared by the first stack of battery cells and the second stack of battery cells.

6. The system of claim 5, wherein the single battery cell is a top battery cell within the first stack of battery cells and a bottom battery cell within the second stack of battery cells.

7. The system of any preceding claim, further comprising one or more additional BCCs, each additional BCC being coupled to monitor an additional stack of battery cells having at least one battery cell shared with a stack of battery cells monitored by another BCC.

8. The system of any preceding claim, wherein each BCC comprises a multiplexer coupled to receive voltage levels from the battery cells as inputs, the multiplexer selecting one of the voltage levels as an output to monitor based upon a control signal.

9. The system of claim 8, wherein the multiplexer in each BCC also receives a diagnostic voltage level as an input that is selectable as the output based upon the control signal.

10. The system of claim 8 or 9, wherein each BCC further comprises a level shifter coupled to receive the output of the multiplexer, an analog-to-digital converter, ADC, coupled to receive an output of the level shifter, and a logic circuit coupled to receive a digital value from the ADC and to output the control signal.

11. A method for battery management, comprising:
monitoring a first stack of battery cells (304) with a first battery cell controller, BCC (302);
monitoring a second stack of battery cells (314) with a second BCC (312), wherein at least one battery cell (308) is a common battery cell shared by the first stack of battery cells (304) and the second stack of battery cells (314);
determining a failure of the first BCC (302) or the second BCC (312) based upon monitoring of the common battery cell (308); and
taking at least one action to protect a battery pack including the first stack of battery cells (304) and the second stack of battery cells (314) based upon the determining.

12. The method of claim 11, wherein the at least one action comprises shutting down the first BCC if the failure is detect in the first BCC or shutting down the second BCC if the failure is detected in the second BCC.

13. The method of claim 11 or 12, wherein the at least one action comprises transmitting a warning message indicating the failure.

14. The method of any of claims 11 to 13, further comprises generating with the first BCC and the second BCC digital values representing monitored cell voltages.

15. The method of claim 14, wherein the determining comprises determining, with a controller, the failure of the first BCC or the second BCC by comparing a first digital value representing a cell voltage for the common battery cell measured by the first BCC and a second digital value representing a cell voltage for the common battery cell measured by the first BCC.
